# EUROPEAN PATENT APPLICATION

(11) **EP 1 263 139 A2**
(43) Date of publication of application: **04.12.2002**
(21) Application number: 02253697.3
(22) Date of filing: 27.05.2002
(51) Int. Cl.: H03K 17/00, G06F 1/08

(54) **Glitch-free multiplexer**

(30) Priority: 30.05.2001 EP 01304738
(71) Applicant: STMicroelectronics Limited, Almondsbury, Bristol BS32 4SQ (GB)
(72) Inventor: Dellow, Andrew, Stroud, Gloucester GL5 3PX (GB); Elliot, Paul, Bristol BS7 8QS (GB)
(74) Representative: Loveless, Ian Mark

(57) **Abstract**

A clock source selector for selecting either a first clock signal A or a second clock signal B in accordance with a switch request signal includes three retiming circuits each consisting of two clocked flip-flops. The switch request signal is first retimed (20,22) relative to clock A to give a signal P, is then retimed (24,26) relative to clock B to give a signal Q, and finally is retimed (28,30) relative to clock A to give a signal R. Selector circuitry (34,40,42) operates such that when signal Q is asserted, the second clock signal B is output, when neither signal P nor signal R, as combined by a NOR gate (34), are asserted, the first clock signal A is output, and at other times a zero level is output. The clock source selector can be used in an integrated circuit to form a glitch-free multiplexer.

## Description

### Background of the Invention

This invention relates to a clock source selector which is capable of switching between two asynchronous clock sources with different clock rates and back again in a glitch-free manner. Such a clock source selector is sometimes termed a glitch-free multiplexer.

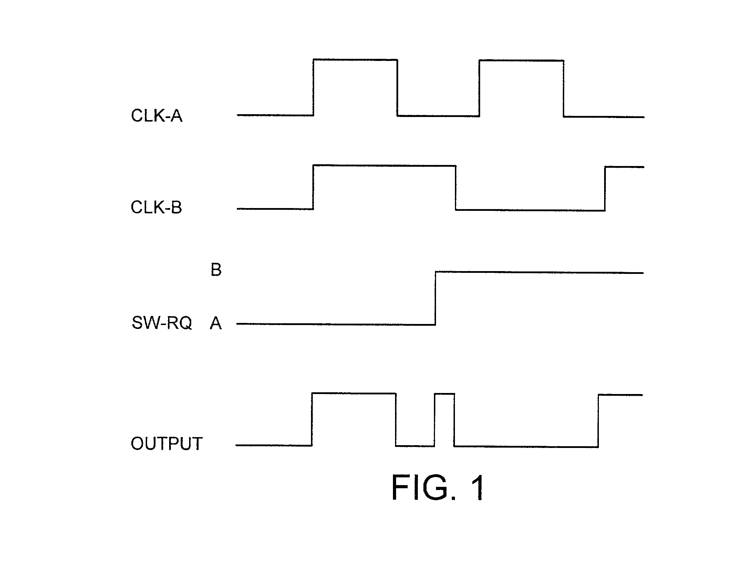

In integrated circuit technology there is sometimes a need to switch between two clock sources which are unrelated in rate and phase. It is important that in such switching any glitch, or short pulse, is avoided. The generation of a glitch is illustrated in Figure 1 of the drawings, which shows two clock waveforms A and B. A switch request signal indicates whether clock A is required or clock B. If clock A is required the switch request (SW-RQ) signal takes a low value, and if clock B is required the switch request signal takes a high value. If the switch request signal is used directly to select clock A or clock B, the output shown at the bottom of the figure is obtained. This includes a short pulse at the point of the changeover, which is unacceptable for many applications. A similar glitch can occur when switching back from clock B to clock A. A glitch-free multiplexer is designed to overcome this problem, and thus is designed so as not to violate the minimum acceptable pulse width.

Known glitch-free multiplexers use state machines and are relatively complex and difficult to test. There is a need for a reliable glitch-free multiplexer which is easy to make and to test, which is reliable when having to cope with successive switch requests, and which does not introduce unnecessary delay.

### Summary of the Invention

The invention is defined in the independent claims below to which reference may now be made. Advantageous features are set forth in the appendant claims.

A preferred embodiment of the invention, described in more detail below with reference to the drawings, takes the form of a clock source for selecting either a first clock signal A or a second clock signal B in accordance with a switch request signal. The clock source includes three retiming circuits each consisting of two clocked flip-flops. The switch request signal is first retimed relative to clock A to give a signal P, is then retimed relative to clock B to give a signal Q, and finally is retimed relative to clock A to give a signal R. Selector circuitry operates such that when signal Q is asserted, the second clock signal B is output, when neither signal P nor signal R, as combined by a NOR gate, are asserted, the first clock signal A is output, and at other times a logic one level is output. The clock source can be used in an integrated circuit to form a glitch-free multiplexer.

### Brief Description of the Drawings

The invention will be described in more detail by way of example with reference to the drawings, in which:
**Figure 1** (referred to above) is a timing diagram illustrating the formation of a glitch;
**Figure 2** is a circuit diagram of a glitch-free multiplexer embodying the invention; and
**Figure 3** is a timing diagram illustrating the operation of the multiplexer.

### Detailed Description of the Preferred Embodiment

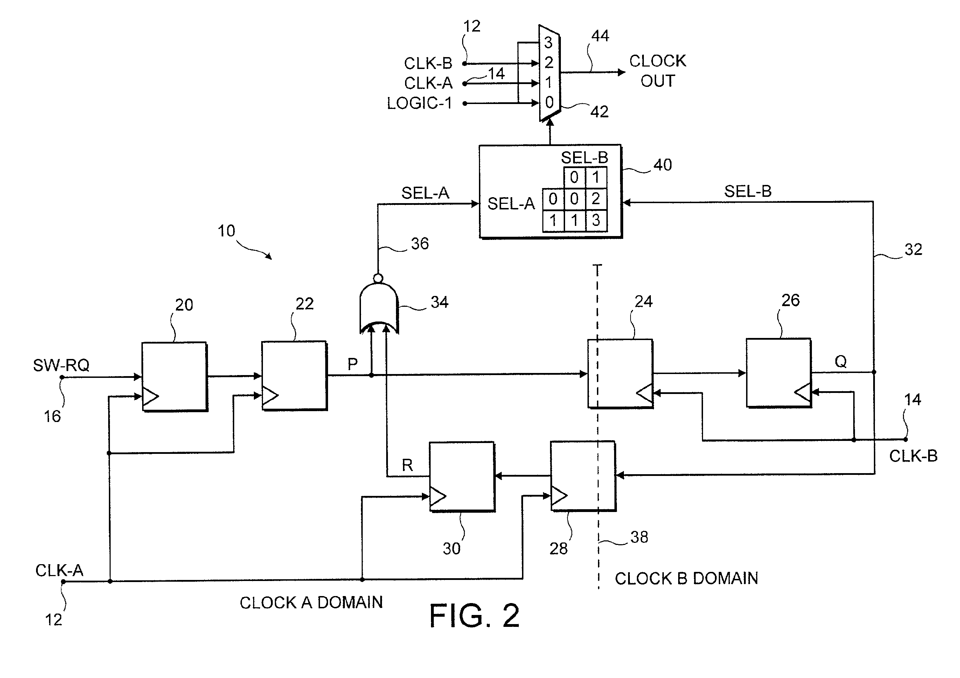

A preferred embodiment of the invention will now be described with reference to Figure 2 of the drawings.

The glitch-free multiplexer 10 illustrated in Figure 2 has an input 12 shown at the bottom left of the Figure for receiving a first clock signal A (CLK-A), an input 14 shown at the right-hand side of the Figure for receiving a second clock signal B (CLK-B), and an input 16 for receiving a switch request signal (SW-RQ). The clocks A and B are asynchronous and unrelated and thus may be of different rate and unrelated phase relationship. The switch request signal is as described above and takes a low value if the output is to follow clock A and a high value if the output is to follow clock B. The switch request signal may therefore be referred to as a 'BnotA' signal.

The construction of the multiplexer 10 is as follows. It is largely constructed from clocked flip-flop or bistable circuits each of which operates to retime the signal applied to its signal input in accordance with a clock input. The switch request signal input is applied to the input of a flip-flop 20 which is connected to input 12 so as to be clocked by clock A. The output of flip-flop 20 is applied to a flip-flop 22 which is also clocked by clock A. The output of flip-flop 22 is supplied to a flip-flop 24 which is connected to input 14 so as to be clocked by clock B. The output of flip-flop 24 is applied to another flip-flop 26 which is also clocked by clock B. The output of flip-flop 26 firstly provides a 'select B' signal SEL-B at an output 32, and secondly is applied to a flip-flop 28 which is connected to input 12 so as to be clocked by clock A. The output of flip-flop 28 is applied to a final flip-flop 30 which is again clocked by clock A. The outputs of flip-flops 22 and 30 are each applied to a respective input of a two-input NOR gate 34, which provides a 'select A' output signal SEL-A at an output 36. The NOR gate 34 provides a high output when and only when both its inputs are low, and is formed by an OR gate with an inverting circuit at its output.

The circuit operates by producing the two outputs SEL-A and SEL-B. These signals are independent to the extent that during a changeover from, say, clock A to clock B, SEL-A is first de-asserted and for a short interval neither SEL-A nor SEL-B is asserted. Then, when it is safe to do so, SEL-B is asserted and clock B takes over.

The manner in which the select signals SEL-A, SEL-B provide an output is also illustrated in Figure 2. The SEL-A and SEL-B signals are applied to a truth table circuit 40 which controls a four-way selector 42. When both SEL-A and SEL-B are low, a defined logic state such as a logic one input is selected. When SEL-A is high and SEL-B is low, CLK-A is selected by selector 42. When SEL-B is high and SEL-A is low, then CLK-B is selected by selector 42. The situation where both SEL-A and SEL-B are high should not arise, but if it did, selector 42 would select the defined logic state such as logic one again. The provision of the defined logic state by the combination of the truth table 40 and multiplexer 42 prevents propogation of a glitch. As the flip-flops within the circuit all clock on the rising edge of the clock input, the defined logic state is chosen to be logic one. The multiplexer output is thus logic one and held at logic one when switching from one clock to another until the clock output can safely be changed to the new clock domain. The output 44 of the selector 42 provides the clock output of the multiplexer.

The operation of the circuit 10 is as follows. First, in flip-flops 20 and 22 the switch request signal is retimed relative to clock A. In accordance with standard practice two successive retiming stages are used for the sake of safety to avoid metastable state propagation. The retimed output of flip-flop 22 may be termed P. Signal P is then retimed by flip-flops 24 and 26 relative to clock B. The retimed output of flip-flop 26 may be termed Q. Signal Q is then retimed back relative to clock A by flip-flops 28 and 30. The retimed output of flip-flop 30 may be termed R.

The signal Q from flip-flop 26 becomes directly the SEL-B signal. The SEL-A signal is generated from a combination of the signals P and R. More particularly, the SEL-A signal is only generated when both the signal P and the signal R are low (de-asserted).

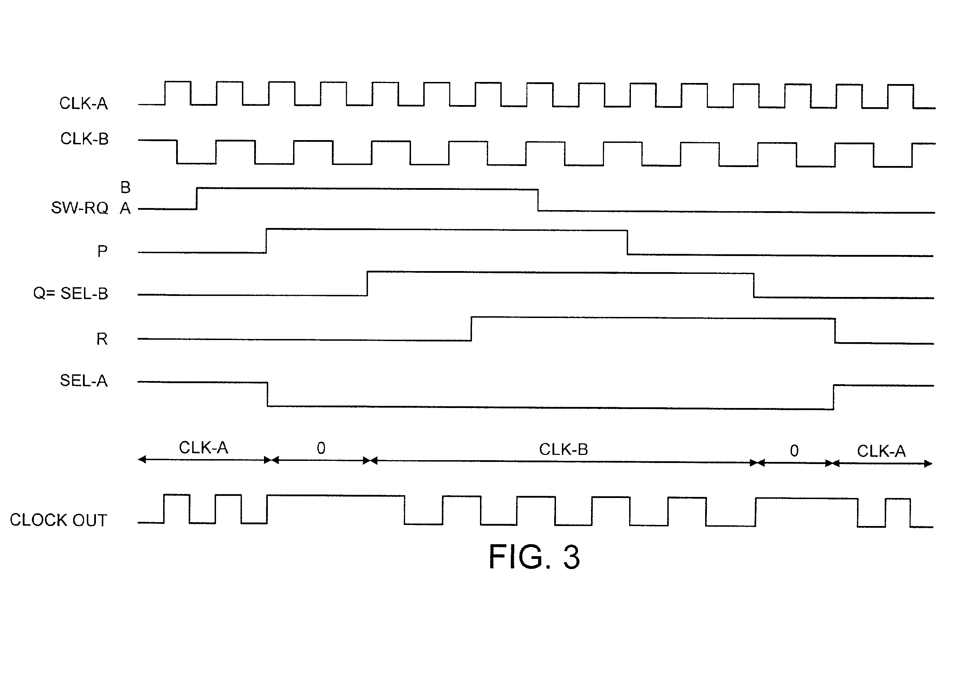

Reference is now made to the waveform diagram of Figure 3 to illustrate the operation of the multiplexer. The clock A and clock B signals are shown at the top of the Figure. The switch request signal SW-RQ is assumed initially to be low, requesting clock A, and then to change to high, requesting clock B, and subsequently to change back again. The signal P will be generated from the switch request signal and will change state on the second rising edge in clock A after the state change in the switch request signal. The signal Q will be generated from the signal P and will change state on the second rising edge in clock B after the state change in the signal P. The signal R will be generated from the signal Q and will change state on the second rising edge in clock A after the state change in signal Q. The signal Q is also the output SEL-B. Finally the signal SEL-A is true when neither P nor R is high.

Looking at Figure 3, it is seen that the effect is that all changes in SEL-A coincide with a pulse of CLK-A and all changes in SEL-B coincide with a pulse of CLK-B. Signal P always precedes Q or SEL-B and signal R always comes after Q or SEL-B. Thus by generating SEL-A only when both P is low and also R is low, the pulses of SEL-B are surrounded by intervals when neither SEL-A nor SEL-B are high, and logic one is applied to the clock output 44 of Figure 2. The resultant clock out signal is shown at the bottom of Figure 3 and is seen to contain no glitches.

The whole circuit is entirely synchronous to the extent that all the flip-flops are clocked either by clock A or clock B. The clock boundary 38 between the clock A domain and the clock B domain is shown on Figure 2. The circuit does not require complex state machines, and is relatively easy both to make and to test. It copes quite happily with successive switch requests, for example where a request to change from clock B to clock A follows closely after a request to change from clock A to clock B. The circuit illustrated is particularly suitable for inclusion in a semiconductor integrated circuit.

Various modifications may be made to the glitch-free multiplexer or clock source 10 shown in Figure 2. If it is known that the switch request signal SW-RQ is always co-timed with clock A, then the flip-flops 20 and 22 can be omitted. In theory, only one flip-flop is needed instead of each of the flip-flop pairs 20,22; 24,26; and 28,30, though this is not preferred for best operation. It does, however, further reduce the delay in the changeover operation. It will be appreciated by those skilled in the art that the logic may be inverted (lows and highs interchanged), either in the circuit as a whole or in selected parts of it, provided that the logical operations effected remain the same. Thus asserting a signal could, in practice, involve taking it from a high value to a low value.

## Claims

1. A clock source selector for selecting a first clock signal or a second clock signal in accordance with a switch request signal, the clock source selector comprising:
a first clock input (12) for receiving a first clock signal;
a second clock input (14) for receiving a second clock signal;
a switch request signal input (16) for receiving a switch request signal which takes a first value when the first clock signal is required and a second value when the second clock signal is required;
a first retiming circuit (24,26) coupled to the switch request signal input and connected to the second clock input to receive the second clock signal for retiming relative to the second clock signal;
a retiming input signal (P) applied thereto, the retiming input signal being timed relative to the first clock signal and comprising the switch request signal or a signal derived therefrom;
a second retiming circuit (28,30) coupled to the output of the first retiming circuit and connected to the first clock input to receive the first clock signal for retiming relative to the first clock signal the output of the first retiming circuit;
selector circuitry (34,40,42) for coupling the second clock input (14) to an output (44) when the output (Q) of the first retiming circuit is asserted and for coupling the first clock input (12) to the output when neither the retiming input signal (P) nor the output (R) of the second retiming circuit are asserted, and for providing a defined logic state on the clock output when both the output of the first retiming circuit is asserted and neither the retiming input signal (P) nor output (R) of the second retiming circuit are asserted.

2. A clock source selector according to claim 1, in which the selector circuitry (34,40,42) provides the defined logic state when both (i) the output (Q) of the first retiming circuit is de-asserted and (ii) either the retiming input signal (P) or the output (R) of the second retiming circuit is asserted.

3. A clock source selector according to claim 1 or 2, in which the selector circuitry includes a two-input NOR gate connected to receive the retiming input signal (P) and the output (R) of the second retiming circuit.

4. A clock source selector according to claim 1, 2 or 3, further comprising a third retiming circuit (20,22) coupled between the switch request signal input and the first retiming circuit and connected to the first clock input to receive the first clock signal for retiming relative to the first clock signal.

5. A clock source selector according to any of claims 1 to 4, in which each retiming circuit comprises two retiming stages.

6. A clock source selector according to any preceding claim, wherein the defined logic state is logic one.

7. A clock source selector according to claim 9, wherein all clocking signals are acted on the leading edge.

8. A clock source selector according to any of claims 1 to 7, wherein the defined logic state is logic zero.

9. A clock source selector according to claim 10, wherein all clocking signals are acted on the trailing edge.

10. A clock source selector according to any preceding claim, wherein the selector circuitry comprises a multiplexer with an input of the defined logic state.

11. A clock source selector according to claim 11, wherein the multiplexer is arranged to directly receive the first clock signal and the second clock signal and to select between the first clock signal, the second clock signal and the defined logic state.

12. A clock source comprising the clock source selector in accordance with any preceding claim.

13. A semiconductor integrated circuit incorporating a clock source selector or clock source in accordance with any preceding claim.
